# EUROPÄISCHE PATENTSCHRIFT

(11) **EP 2 556 005 B1**
(45) Veröffentlichungstag und Bekanntmachung des Hinweises auf die Patenterteilung: **01.04.2015**
(21) Anmeldenummer: 11723887.3
(22) Anmeldetag: 04.06.2011
(51) Int. Cl.: B65G 49/06, B65G 51/03, H01L 21/677

(54) **LUFTLAGEREINRICHTUNG**
PNEUMATIC BEARING DEVICE
DISPOSITIF DE COUSSIN D'AIR

(30) Priorität: 18.06.2010 DE 102010024263
(43) Veröffentlichungstag der Anmeldung: 13.02.2013
(73) Patentinhaber: Festo AG & Co. KG, 73734 Esslingen (DE)
(72) Erfinder: SIEBER, Manuel, Taipei City, 111 55 Shilin (TW); BIDMON, Michael, 73345 Hohenstadt (DE); KEICHER, Christoph, 72070 Tübingen (DE); PATTORA, Ronny, 73669 Lichtenwald (DE)
(74) Vertreter: Patentanwälte Magenbauer & Kollegen Partnerschaft mbB
(86) Internationale Anmeldenummer: PCT/EP2011/002752
(87) Internationale Veröffentlichungsnummer: WO 2011/157363

(56) Entgegenhaltungen:
- EP-A1- 1 461 826
- WO-A2-2008/035324
- US-A- 6 027 112
- US-A1- 2010 209 082
- US-B1- 6 781 684
- US-B2- 7 603 028

## Beschreibung

Die Erfindung betrifft eine Luftlagereinrichtung, mit wenigstens einem Lagerkörper, der eine Vielzahl von an einer Lagerfläche des Lagerkörpers ausmündende Ausströmkanäle aufweist, durch die hindurch Druckluft leitbar ist, wobei die Lagerfläche mit einer ihr zugewandten Gegenfläche eines Substratkörpers derart zusammenwirkt, dass zwischen Lagerfläche und Gegenfläche durch die ausströmende Druckluft ein Luftpolster erzeugbar ist, das einen Lagerspalt hervorruft, wodurch die beiden Flächen entsprechend einer Spaltweite des Lagerspalts mit Abstand zueinander angeordnet sind, wobei der Lagerkörper als erster Lagerkörper Bestandteil einer pneumatischen Spanneinrichtung ist, die zusätzlich einen zweiten Lagerkörper mit einer Vielzahl von einer an einer zweiten Lagerfläche des zweiten Lagerkörpers ausmündenden Ausströmkanäle aufweist, wobei die beiden Lagerflächen einander gegenüberliegen und der Substratkörper derart zwischen den Lagerflächen positionierbar ist, dass er durch die beiden zwischen den Lagerflächen und den jeweils zugeordneten Gegenflächen erzeugten Luftpolster diesseits und jenseits des Substratkörpers in gewünschter Position in Richtung senkrecht zu den Lagerflächen pneumatisch festspannbar ist,

Im Allgemeinen werden Luftlager eingesetzt, wenn in Bezug auf die Leichtgängigkeit und die Verschleißanfälligkeit besonders hohe Anforderungen gestellt werden. Luftlager zeichnen sich konzeptbedingt durch Verschleißfreiheit, hohe Tragkraft und besonders ruhiges Laufverhalten aus. Beim Einsatz von Luftlagern wird unter Druck stehende Luft zwischen die relativ zueinander bewegbaren Bauteile gepresst, so dass sich ein Luftpolster bildet, das die Bauteile auf Abstand hält.

Typische Produkte, die mit solchen Luftlagern transportiert werden, sind Solarpaneele, Wafer und Flachbildschirmscheiben, die auch als so genanntes Flat-Panel-Display (FPD) Screens bezeichnet werden. Insbesondere solche FPD-Screens haben eine sehr geringe Dicke beispielsweise im Bereich von 0,7 mm, besitzen aber gleichzeitig eine relativ große Fläche. Dadurch neigen solche FPD-Screens beispielsweise an den Ecken zu einer Aufbiegung, während sie in der Mitte durchhängen. Auch eine Veränderung der Höhenposition bezüglich des Luftlagers durch Schwingungen solcher FPD-Screens ist zu beobachten, beispielsweise verursacht durch Luftverwirbelungen, wie sie bei der Produktion in Reinräumen durch den Laminar-Flow von Filterfan-Units auftreten.

Um diesem Problem zu begegnen, ist es bereits aus dem Stand der Technik, beispielsweise aus der WO 2006/052919 A1, bekannt, das Substrat, beispielsweise in Form solcher FPD-Screens, in einer stabilen Höhenposition bezüglich des Luftlagers zu fixieren und zwar durch Anlegen eines Vakuums, das das Substrat bzw. den Substratkörper auf das Luftpolster drückt und dort fixiert. Bei solchen Luftlagern wechseln sich also Ausströmöffnungen für die Druckluft zur Herstellung des Luftpolsters und Vakuumansaugöffnungen ab. Allerdings ist die Bereitstellung von Vakuum mit nicht unerheblichen Kosten verbunden, da zusätzlich zu der ohnehin benötigten Druckluft noch ein Vakuumerzeuger bereitgestellt und betrieben werden muss.

Aus der EP 1 378 766 A1 ist ebenfalls eine Luftlagereinrichtung bekannt, die zur luftgefederten Lagerung einer plattenartigen Ablagefläche dient. Die Luftlagereinrichtung besteht aus zwei Lagerhälften, die sich an zwei entgegengesetzten Rändern der Ablagefläche befinden. Die Lagerhälften besitzen jeweils mehrere Luftlagerelemente, wobei die Ablagefläche an beiden Rändern zwischen jeweils zwei solcher Luftlagerelemente sitzt, wodurch eine Fixierung in Vertikalrichtung erfolgt. Darüber hinaus befindet sich die Ablagefläche zusätzlich zwischen zwei Luftlagerelementen, die einerseits an der einen Lagerhälfte und andererseits an der anderen Lagerhälfte angeordnet sind, wodurch die Ablagefläche auch in Horizontalrichtung gegen Verschieben gesichert ist. Die Luftlagerung der Ablagefläche ist auf deren Ränder begrenzt. Eine solche Luftlagerung ist weder für sich bewegende bzw. zu fördernde Substratkörper noch für Substratkörper mit geringer Dicke, wie beispielsweise FPD-Screens, geeignet.

Die DE 10 2005 007 079 A1 zeigt ein luftgelagertes Portal, mit zwei parallel zueinander angeordneten Schienen, auf denen ein Träger linear beweglich geführt ist. Die Luftlagerelemente befinden sich an einander entgegengesetzten Enden des Trägers bzw. an den Schienen im Bereich der Führungen, wodurch ein nahezu verschleißfreier Lauf des Trägers ermöglicht wird. Die Luftlager sind auch hier auf die Lagerbereiche des Trägers an der Schiene beschränkt.

Die WO 2008/035324 A1 offenbart eine Vorrichtung zur Fluidbehandlung, wobei ein Substratkörper zwischen zwei mit jeweils einer Vielzahl von Ausströmkanälen versehenen Lagerkörpern pneumatisch eingespannt ist.

Die EP 1 461 826 A1 offenbart eine Luftlagereinrichtung mit einer eine Vielzahl von Ausströmöffnungen versehenen Plattform. Zwischen der Plattform und dem zu transportierenden Substratkörper, beispielsweise ein Flat Panel Display, baut sich ein Luftkissen auf, wodurch der Substratkörper berührungslos befördert wird. In einer Ausgestaltung der Luftlagereinrichtung sind beidseits des zu transportierenden Substratkörpers solche Plattformen angeordnet, wodurch der Substratkörper senkrecht zur Transportrichtung pneumatisch festspannbar ist.

Die US 7,603,028 B2 offenbart ebenfalls eine Luftlagereinrichtung zum berührungslosen Transport von Flat Panel Displays, die zwischen zwei Plattformen pneumatisch einspannbar sind.

Aufgabe der Erfindung ist es, eine Luftlagereinrichtung der eingangs erwähnten Art zu schaffen, mit der auch dünne, großflächige und sich bewegende Substratkörper zuverlässig und verschleißfrei gelagert und befördert werden können. Diese Aufgabe wird durch eine Luftlagereinrichtung mit den Merkmalen des unabhängigen Anspruchs 1 gelöst. Weiterbildungen der Erfindung sind in den Unteransprüchen dargestellt.

Die erfindungsgemäße Luftlagereinrichtung zeichnet sich dadurch aus, dass wenigstens einem der Lagerkörper eine Verstelleinrichtung zur Einstellung unterschiedlicher Abstände zwischen den Lagerflächen der Lagerkörper zugeordnet ist, wobei die Verstelleinrichtung einen Stellantrieb aufweist, der über Übersetzungsmittel mit dem zugeordneten Lagerkörper bewegungsgekoppelt ist.

Die beiden Luftpolster werden also beidseits des Substratkörpers großflächig aufgebaut, wodurch der Substratkörper in seiner Höhenlage also in Richtung quer zu den Lagerflächen der Lagerkörper lagefixiert ist. Durch den großflächigen Aufbau der Luftpolster können auch die bereits vorstehend erwähnten Substratkörper mit relativ geringer Dicke, wie FPD-Screens, Wafer oder Solarpaneele zuverlässig gelagert und transportiert werden. Durch die Fixierung zwischen den beiden Luftpolstern ist es möglich, nachfolgende Bearbeitungsschritte am Substratkörper, beispielsweise eine Laser-Bearbeitung, zuverlässig auszuführen. Gerade bei einer solchen Laser-Bearbeitung müsste der Laser ständig seine Fokussierung ändern, würde der Substratkörper in Höhenrichtung nicht fixiert sein.

Bei einer Weiterbildung der Erfindung ist wenigstens einem der Lagerkörper ein Druckregler und/oder Volumenstromregler zur Einstellung unterschiedlicher Drücke und/oder Volumenströme der durch die Ausströmkanäle ausströmenden Druckluft und somit der Einstellung unterschiedlicher Spaltbreiten zugeordnet. Dadurch ist eine exakte Positionierung des Substratkörpers zwischen den Lagerflächen möglich. Darüber hinaus lässt sich eine einmal eingestellte Position des Substratkörpers in einfacher Weise nachträglich ändern. Bei Änderung des Drucks oder des Volumenstroms an einem der beiden Lagerkörper wird der Substratkörper also relativ zu dem Lagerkörper, an dem das Luftpolster mit geringerem Druck ausgebildet ist, verlagert.

In besonders bevorzugter Weise findet eine kontinuierliche Positionsüberwachung der Position des Substratkörpers zwischen den beiden Lagerflächen statt. Hierzu besitzt die Luftlagereinrichtung zweckmäßigerweise eine Spaltweiten-Überwachungseinrichtung zur Überwachung der Spaltweiten der Luftspalte zwischen Substratkörper und Lagerkörper.

In besonders bevorzugter Weise ist die Spaltweiten-Überwachungseinrichtung derart ausgebildet, dass eine Überwachung der Spaltweiten unabhängig von der die Luftpolster erzeugenden Druckluft möglich ist. Es wird also nicht der Druck und/oder der Durchfluss im Ausströmkanal bzw. in einem zu den Ausströmkanälen führenden Versorgungskanal detektiert, sondern es wird vor Ort am Lagerkörper überwacht. Die Überwachung ist unabhängig von der die Luftpolster erzeugenden Druckluft.

Zweckmäßigerweise weist die Spaltweiten-Überwachungseinrichtung wenigstens einen Überwachungssensor auf, mittels dem Ist-Spaltweiten detektierbar sind und der im Falle einer Unterschreitung einer hinterlegten Mindest-Spaltweite ein Fehlersignal ausgibt. Gegebenenfalls kann der Überwachungssensor mit Auswertemitteln gekoppelt sein, in denen eine gewünschte Mindest-Spaltweite hinterlegt ist, die mit einer vom Überwachungssensor detektiert Ist-Spaltweite verglichen wird, wobei bei Unterschreitung der Mindest-Spaltweite ein Fehlersignal ausgegeben wird.

Der Überwachungssensor kann beispielsweise als Luftspaltsensor ausgebildet sein. Alternativ ist es möglich, einen optischen oder magnetischen Überwachungssensor einzusetzen.

Wenigstens einem der Lagerkörper ist eine Verstelleinrichtung zur Einstellung unterschiedlicher Abstände zwischen den Lagerflächen der Lagerkörper zugeordnet. Dadurch lässt sich der Abstand zwischen den beiden Lagerflächen der Lagerkörper verändern, beispielsweise vergrößern, um auch Substratkörper mit größerer Dicke aufnehmen zu können. Zweckmäßigerweise wird ein statischer und ein beweglicher Lagerkörper eingesetzt. Ferner ist es möglich, die Luftspalte zwischen den Lagerflächen und den zugeordneten Gegenflächen durch Verlagerung des beweglichen bzw. dynamischen Lagerkörpers zu verändern.

Die Verstelleinrichtung weist einen Stellantrieb auf, der über Übersetzungsmittel mit dem zugeordneten Lagerkörper gekoppelt ist.

In besonders bevorzugter Weise ist eine Steuereinrichtung vorgesehen, die einerseits mit der Spaltweiten-Überwachungseinrichtung und andererseits mit dem Stellantrieb und/oder dem Druckregler und/oder dem Volumenstromregler zur gesteuerten Einstellung der Spaltweiten der Luftspalte gekoppelt ist. Es kann also ein Regelkreis gebildet werden, so dass eine kontinuierliche Positionsüberwachung und -korrektur der Lage des Substratkörpers stattfindet. Damit lassen sich Substratkörpertoleranzen insbesondere Dickenunterschiede insitu derart ausgleichen, dass sich die Substratoberseite stets auf exakt demselben Höhenniveau zwischen den Lagerkörpern befindet.

Bevorzugte Ausführungsbeispiele der Erfindung sind in der Zeichnung dargestellt und werden im Folgenden näher erläutert. In der Zeichnung zeigen:
- Figur 1: eine schematische Darstellung eines ersten Ausführungsbeispiels der erfindungsgemäßen Luftlagereinrichtung,
- Figur 2: ein zweites Ausführungsbeispiel der Luftlagereinrichtung ebenfalls in schematischer Darstellung und
- Figur 3: eine schematische Darstellung eines dritten Ausführungsbeispiels der erfindungsgemäßen Luftlagereinrichtung.

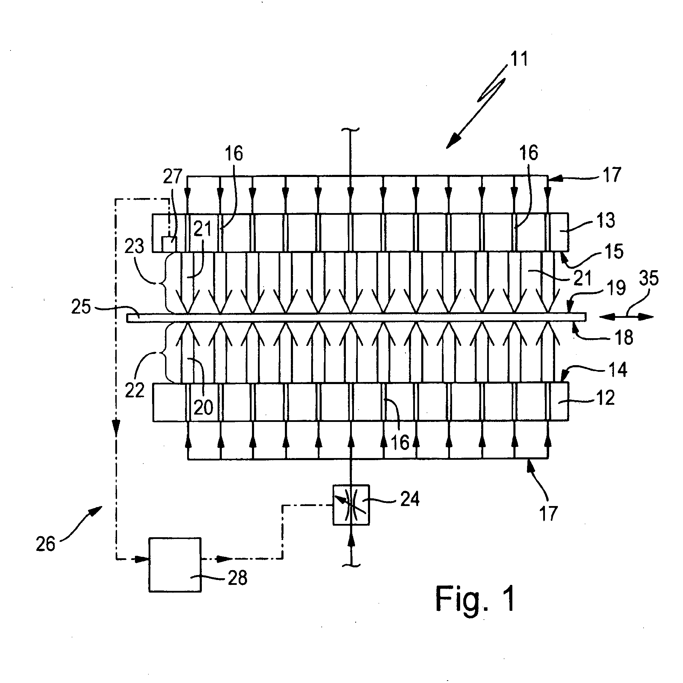

Die Figur 1 zeigt ein erstes Ausführungsbeispiel der erfindungsgemäßen Luftlagereinrichtung 11. Die Luftlagereinrichtung 11 verfügt über einen ersten und zweiten Lagerkörper 12, 13, die sich mit ihren jeweiligen Lagerflächen 14, 15 einander gegenüberliegen. Gemäß erstem Ausführungsbeispiel bestehen die Lagerkörper 12, 13 jeweils aus luftundurchlässigem Material, durch das hindurch sich eine Vielzahl von Ausströmkanälen 16 hindurch erstreckt, durch die hindurch Druckluft geleitet werden kann. Die Ausströmkanäle 16 münden in Form von Ausströmmündungen an ersten bzw. zweiten Lagerflächen 14, 15 der Lagerkörper 12, 13 aus. Die Ausströmmündungen sind jeweils im Wesentlichen über die gesamte Lagerfläche 14, 15 verteilt angeordnet. Die Ausströmkanäle können beispielsweise in regelmäßigen Abständen in Längsrichtung der Lagerkörper 14, 15 hintereinander angeordnet sein, wie es beispielsweise in Figur 1 gezeigt ist. Es ist jedoch aus möglich, dass die Ausströmkanäle 16 in Kanalgruppen (nicht dargestellt) gruppiert sind, die dann jeweils eine bestimmte Anzahl an Ausströmkanälen 16 aufweisen. Diese Kanalgruppen sind dann ebenfalls im Wesentlichen über die gesamten Lagerflächen 14, 15 verteilt angeordnet.

Wie insbesondere in Figur 1 dargestellt, werden die Ausströmkanäle 16 mit Druckluft durchströmt, das von einer Druckluftquelle (nicht dargestellt) stammt und zweckmäßigerweise über einen zentralen Zuführkanal zugeführt wird. Von dort gelangt die Druckluft in einen Verteiler 17, von wo aus sie zu den einzelnen Ausströmkanälen geführt wird.

Zwischen dem ersten und dem zweiten Lagerkörper 12, 13 befindet sich ein Substratkörper 25, beispielsweise in Form eines Solarpaneels oder FPD-Screens, der zwei einander entgegengesetzte Gegenflächen 18, 19 aufweist, die jeweils mit der ersten oder zweiten Lagerfläche 14, 15 der Lagerkörper 12, 13 derart zusammenwirken, dass zwischen den Lagerflächen 14, 15 und den jeweils zugeordneten Gegenflächen 18, 19 durch die ausströmende Druckluft Luftpolster 20, 21 erzeugt werden. Die Luftpolster rufen einen ersten und einen zweiten Lagerspalt 22, 23 hervor, wodurch der Substratkörper 25 in Folge der Luftpolster 20, 21 auf Abstand zu den Lagerflächen 14, 15 gehalten wird.

Der erste und der zweite Lagerkörper 12, 13 und die hierdurch erzeugbaren Luftpolster 20, 21 bilden gemeinsam eine pneumatische Spanneinrichtung 26. Der Substratkörper 25 wird durch die zwischen den Lagerflächen 14, 15 und den jeweils zugeordneten Gegenflächen 18, 19 erzeugten Luftpolster 20, 21 diesseits und jenseits des Substratkörpers 25 in gewünschter Position in Richtung senkrecht zu den Lagerflächen 14, 15 pneumatisch festgespannt.

Gemäß dem ersten Ausführungsbeispiel sind die beiden Lagerkörper 12, 13 stationär ausgeführt, während der Substratkörper 25 gleichwohl er in bestimmter Höhenlage zwischen den beiden Lagerflächen 14, 15 pneumatisch festgespannt ist, in einer Bewegungsrichtung im Wesentlichen parallel zu den Lagerflächen 14, 15 beweglich ist. Die Bewegungsrichtung kann dabei in die durch Doppelpfeil 35 dargestellten zwei entgegengesetzten Bewegungsrichtungen auf folgen.

Die Luftlagereinrichtung 11 umfasst ferner gemäß dem in Figur 1 dargestellten ersten Ausführungsbeispiel einen Druckregler 24, mit dem sich der Druck der durch die Ausströmkanäle 16 strömenden Druckluft einstellen lässt. Zweckmäßigerweise ist nur dem ersten Lagerkörper 12 ein solcher Druckregler 24 zugeordnet. Prinzipiell könnte natürlich auch der zweite Lagerkörper 13 einen Druckregler besitzen. Wird der Druck mittels des Druckreglers 24 erhöht, so erhöht sich auch der Druck im Luftpolster 20 über der ersten Lagerfläche 14. Dies hat zur Folge, dass der Substratkörper 25 in Richtung des niedrigeren Druckes, also gegen das Luftpolster 21 unterhalb der zweiten Lagerfläche 15 gedrückt wird. Dadurch wird die Spaltweite des ersten Lagerspalts 22 vergrößert, während sich die Spaltweite des zweiten Lagerspaltes 23 verringert. Es ist also eine Änderung der Position des Substratkörpers 25 in Richtung senkrecht zu den Lagerflächen 14, 15 durch Änderung des Drucks im Luftpolster 20 möglich. Den gleichen Effekt könnte man auch durch einen Volumenstromregler erzielen, wobei in diesem Fall dann der Volumenstrom, der durch die Ausströmkanäle 16 strömenden Druckluft, variiert werden würde.

Die Luftlagereinrichtung 11 besitzt ferner eine Spaltweiten-Überwachungseinrichtung 26, die unabhängig von der die Luftpolster 20, 21 erzeugenden Druckluft arbeitet und mit der sich die Spaltweiten der zwischen den Lagerflächen 14, 15 und den Gegenflächen 18, 19 ausgebildeten Lagerspalte 22, 23 überwachen lassen. Die Spaltweiten-Überwachungseinrichtung 26 weist einen Überwachungssensor 27 auf, der gemäß erstem Ausführungsbeispiel als Luftspaltsensor ausgebildet ist. Der Überwachungssensor 27 ist mit einer Steuereinrichtung 28 gekoppelt, beispielsweise mittels einer Signalleitung oder drahtlos, in der eine gewünschte Mindest-Spaltweite hinterlegt werden kann, die mit einer vom Überwachungssensor detektierten Ist-Spaltweite vergleichbar ist, wobei bei Unterschreitung der Mindest-Spaltweite ein Fehlersignal ausgebbar ist. Ferner kann in der Steuereinrichtung 28 auch eine Soll-Spaltweite hinterlegt sein, die exakt eingehalten werden soll. Zweckmäßigerweise befindet sich der Überwachungssensor 27 am oberen zweiten Lagerkörper 14, überwacht also die Spaltweite zwischen der zweiten Lagerfläche 15 und der zugehörigen Gegenfläche 19, also der Substratoberfläche. Ändert sich die Lage der Substratoberfläche in Bezug zu der zweiten Lagerfläche 15, so wird ein Signal an die Steuereinrichtung 28 ausgegeben, die wiederum ein Steuersignal an den Druckregler ausgibt, der den Druck des Luftpolsters 20 derart ändert, dass die Lage der Substratoberfläche wieder exakt mit der Soll-Spaltweite korreliert. Eine Lageänderung der Substratoberfläche kann beispielsweise infolge von Maßtoleranzen insbesondere bezüglich der Dicke des Substratkörpers 25 erfolgen.

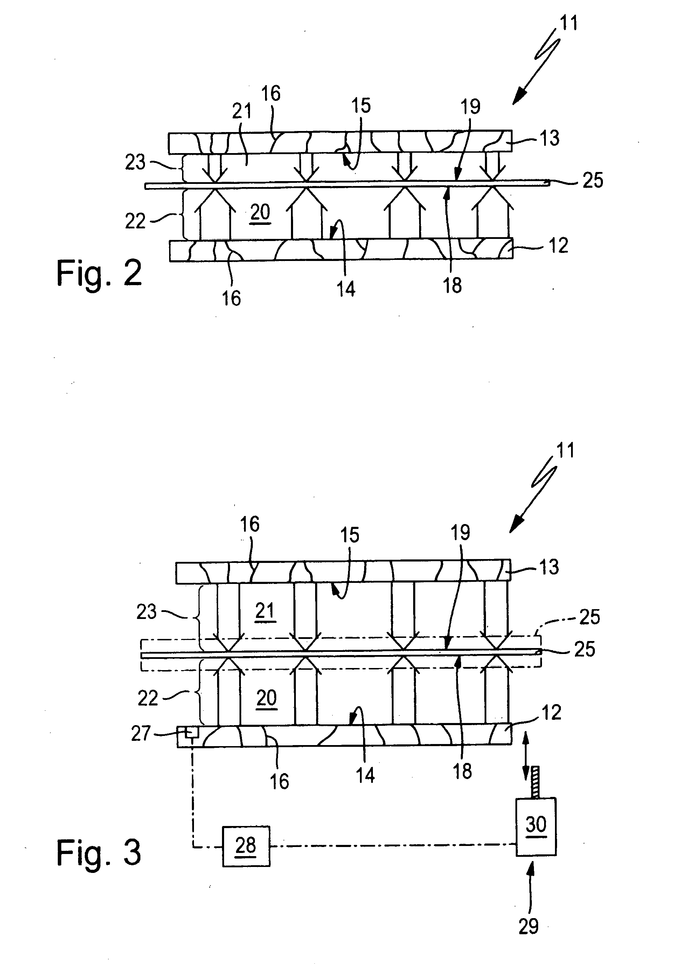

Figur 2 zeigt ein zweites Ausführungsbeispiel der erfindungsgemäßen Luftlagereinrichtung 11. Es unterscheidet sich vom in Figur 1 dargestellten ersten Ausführungsbeispiel lediglich in der Ausgestaltung bzw. dem Aufbau der Lagerkörper 12, 13. Die Lagerkörper 12, 13 gemäß dem zweiten Ausführungsbeispiel bestehen aus porösem Material, beispielsweise Keramikmaterial, das luftdurchlässig ist, wobei in den Lagerkörpern 12, 13 auf Grund der Porösität eine Vielzahl von Ausströmkanälen 16 gebildet werden, die an den Lagerflächen 14, 15 der Lagerkörper 12, 13 ausmünden. Durch die Vielzahl von Ausströmkanälen 16 wird also eine Art Mikrokanalsystem gebildet, das gewährleistet, dass Druckluft im Wesentlichen gleichmäßig über die Lagerflächen 14, 15 verteilt austritt und somit ein großflächiges und gleichmäßiges Luftpolster bildet. In Figur 2 ist darüber hinaus grob schematisch die Änderung der Spaltweite in Folge einer Druckänderung bzw. Volumenstromänderung gezeigt. Dabei korrespondieren die dickeren Pfeile mit dem erhöhten Druck bzw. vergrößerten Volumenstrom.

Schließlich ist in Figur 3 ein drittes Ausführungsbeispiel der erfindungsgemäßen Luftlagereinrichtung 11 dargestellt. Hinsichtlich des Aufbaus der Lagerkörper 12, 13 stimmt dieses dritte Ausführungsbeispiel mit dem zuvor beschriebenen zweiten Ausführungsbeispiel überein. Ein weiterer Unterschied bezüglich zuvor beschriebenen Ausführungsbeispielen besteht hier darin, dass einer der Lagerkörper, zum Beispiel der erste Lagerkörper 12 beweglich gelagert ist, derart, dass er auf den statischen zweiten Lagerkörper 13 zu oder von diesem wegbewegbar ist. Hierzu ist eine Verstelleinrichtung 29 vorgesehen, die einen Stellantrieb 30 aufweist, der über Übersetzungsmittel mit dem zugeordneten Lagerkörper 12 gekoppelt ist. Als Stellantrieb 30 ist hier rein beispielhaft ein elektrischer Spindelantrieb dargestellt, dessen Spindel auch für sehr kurzhubige translatorische Stellbewegungen geeignet ist. Der Stellantrieb 30 ist signaltechnisch mit der Steuereinrichtung 28 gekoppelt und empfängt Steuersignale, wodurch der Stellantrieb 30 veranlasst wird, den Abstand zwischen den beiden Lagerflächen 12, 13 zu ändern. Dies kann beispielsweise der Fall sein, wenn zunächst FPD-Screens, die eine durchschnittliche Dicke von ca. 0,7 mm aufweisen, befördert werden und danach ein Chargenwechsel auf beispielsweise Solarpaneele stattfindet, die typischerweise eine Dicke von 3,2 mm besitzen. Der Abstand der beiden Lagerflächen 14, 15 zueinander muss dementsprechend vergrößert werden. Ferner ist auch hier eine automatische Kompensation von Werkstücktoleranzen möglich.

Im Betrieb der Luftlagereinrichtung fährt der Substratkörper, beispielsweise ein Solarpaneel oder ein FPD-Screen zunächst in den Zwischenraum zwischen den beiden Lagerkörpern 12, 13 ein. Aus den Ausströmkanälen 16 strömt bereits Druckluft aus, die an die Substratoberseite bzw. -unterseite, also an die Gegenflächen 18, 19, prallt. Dadurch wird zwischen der Substratoberseite und der zweiten Lagerfläche 15 und der Substratunterseite und der ersten Lagerfläche 14 jeweils ein Luftpolster 20, 21 ausgebildet, die den Substratkörper 25 in gewünschter Höhenlage zwischen den beiden Lagerkörpern pneumatisch festspannen. Der Substratkörper 25 wird dann durch die Luftlagereinrichtung 11 befördert und gelangt dann entweder zu einer anderen Bearbeitungsstation, beispielsweise einer Laserstation oder in die nächste Luftlagereinrichtung 11. Wird beim Einlauf des Substratkörpers 25 festgestellt, dass die mittels des Überwachungssensors 27 ermittelte Soll-Spaltweite zwischen der Substratoberseite und der zweiten Lagerfläche von der Soll-Spaltweite abweicht, so wird ein Signal an die Steuereinrichtung 28 ausgegeben, die ihrerseits ein Steuersignal an den Volumenstromregler bzw. gemäß Figur 1 Druckregler ausgibt, der den Zustand des zwischen der Substratunterseite und der ersten Lagerfläche 14 ausgebildeten Luftpolsters derart ändert, dass die Substratoberseite wieder in die exakte Soll-Position kommt, die mit der Soll-Spaltweite korreliert. Alternativ oder zusätzlich kann einer der Lagerkörper wie gemäß Figur 3 dargestellt, beweglich mittels einer Verstelleinrichtung 29 geführt sein, so dass durch Veränderung des Abstandes zwischen den beiden Lagerkörpern auch auf Substratkörper unterschiedlicher Dicken umgestellt werden kann.

## Patentansprüche

1. Luftlagereinrichtung, mit wenigstens einem Lagerkörper (12, 13), der eine Vielzahl von an einer Lagerfläche (14, 15) des Lagerkörpers (12, 13) ausmündenden Ausströmkanälen (16) aufweist, durch die hindurch Druckluft leitbar ist, wobei die Lagerfläche (14, 15) mit einer ihr zugewandten Gegenfläche (18, 19) eines Substratkörpers (25) derart zusammenwirkt, dass zwischen Lagerfläche (14, 15) und Gegenfläche (18, 19) durch die ausströmende Druckluft ein Luftpolster (20, 21) erzeugbar ist, das einen Lagerspalt (22, 23) hervorruft, wodurch die beiden Flächen entsprechend einer Spaltweite des Lagerspalts (22, 23) mit Abstand zueinander angeordnet sind, wobei der Lagerkörper (12, 13) als erster Lagerkörper (12) Bestandteil einer pneumatischen Spanneinrichtung (40) ist, die zusätzlich einen zweiten Lagerkörper (13) mit einer Vielzahl von einer an einer zweiten Lagerfläche (15) des zweiten Lagerkörpers (13) ausmündenden Ausströmkanäle (16) aufweist, wobei die beiden Lagerflächen (14, 15) einander gegenüberliegen und der Substratkörper (25) derart zwischen den Lagerflächen (14, 15) positionierbar ist, dass er durch die beiden zwischen den Lagerflächen (14, 15) und den jeweils zugeordneten Gegenflächen (18, 19) erzeugten Luftpolster (20, 21) diesseits und jenseits des Substratkörpers (25) in gewünschter Position in Richtung senkrecht zu den Lagerflächen (14, 15) pneumatisch festspannbar ist, **dadurch gekennzeichnet, dass** wenigstens einem der Lagerkörper (12, 13) eine Verstelleinrichtung (29) zur Einstellung unterschiedlicher Abstände zwischen den Lagerflächen (14, 15) der Lagerkörper (12, 13) zugeordnet ist, wobei die Verstelleinrichtung einen Stellantrieb aufweist, der über Übersetzungsmittel mit dem zugeordneten Lagerkörper (12, 13) bewegungsgekoppelt ist.

2. Luftlagereinrichtung nach Anspruch 1, **dadurch gekennzeichnet, dass** wenigstens einem der Lagerkörper (12, 13) ein Druckregler (24) und/oder Volumenstromregler zur Einstellung unterschiedlicher Drücke und/oder Volumenströme der durch die Ausströmkanäle (16) strömenden Druckluft und somit der Einstellung unterschiedlicher Spaltweiten zugeordnet ist.

3. Luftlagereinrichtung nach anspruch 1 gekennzeichnet durch eine Spaltweiten-Überwachungseinrichtung (26) zur Überwachung der Spaltweiten der Lagerspalte (22, 23).

4. Luftlagereinrichtung nach Anspruch 3, **dadurch gekennzeichnet, dass** die Spaltweiten-Überwachungseinrichtung (26) derart ausgebildet ist, dass eine Überwachung der Spaltweite unabhängig von der die Luftpolster (20, 21) erzeugenden Druckluft möglich ist.

5. Luftlagereinrichtung nach Anspruch 3 oder 4, **dadurch gekennzeichnet, dass** die Spaltweiten-Überwachungseinrichtung (26) wenigstens einen Überwachungssensor (27) aufweist, mittels dem Ist-Spaltweiten detektierbar sind und der im Falle einer Unterschreitung einer hinterlegten Mindest-Spaltweite ein Fehlersignal ausgibt.

6. Luftlagereinrichtung nach Anspruch 5, **dadurch gekennzeichnet, dass** der Überwachungssensor als Luftspaltsensor ausgebildet ist.

7. Luftlagereinrichtung nach Anspruch 2, 3 und 6, **dadurch gekennzeichnet, dass** eine Steuereinrichtung (28) vorgesehen ist, die einerseits mit der Spaltweiten-Überwachungseinrichtung (26) und andererseits mit dem Stellantrieb (30) und/oder dem Druckregler (24) und/oder dem Volumenstromregler zur gesteuerten Einstellung der Spaltweiten der Lagerspalte (22, 23) gekoppelt ist.

## Claims

1. Air bearing device with at least one bearing body (12, 13) which has a multiplicity of discharge passages (16) opening out at a bearing surface (14, 15) of the bearing body (12, 13) and through which compressed air may be fed, wherein the bearing surface (14, 15) cooperates with a facing mating surface (18, 19) of a substrate body (25), in such a way that between the bearing surface (14, 15) and the mating surface (18, 19) the outflowing compressed air is able to generate an air cushion (20, 21) which creates a bearing gap (22, 23), by which means the two surfaces are arranged at a distance from one another corresponding to a gap width of the bearing gap (22, 23), wherein the bearing body (12, 13) as first bearing body (12) is part of a pneumatic clamping fixture (40), which in addition has a second bearing body (13) with a multiplicity of discharge passages (16) opening out at a second bearing surface (15) of the second bearing body (13), wherein the two bearing surfaces (14, 15) lie opposite one another, and the substrate body (25) may be so positioned between the bearing surfaces (14, 15) that it may be clamped pneumatically by the two air cushions (20, 21) created between the bearing surfaces (14, 15) and the respectively assigned mating surfaces (18, 19) on one side and the other of the substrate body (25) in a desired position perpendicular to the bearing surfaces (14, 15), **characterised in that** at least one of the bearing bodies (12, 13) is assigned an adjusting device (29) for setting various distances between the bearing surfaces (14, 15) of the bearing bodies (12, 13), wherein the adjusting device has an actuator which is movement-coupled via transmission means to the assigned bearing body (12, 13).

2. Air bearing device according to claim 1, **characterised in that** at least one of the bearing bodies (12, 13) is assigned a pressure regulator (24) and/or volumetric flow regulator for the setting of different pressures and/or volumetric flows of the compressed air flowing through the discharge passages (16) and consequently the setting of different gap widths.

3. Air bearing device according to claim 1, **characterised by** a gap-width monitoring device (26) for monitoring the gap widths of the bearing gaps (22, 23).

4. Air bearing device according to claim field unit (3), **characterised in that** the gap-width monitoring device (26) is so designed that monitoring of gap widths is possible independently of the compressed air creating the air cushions (20, 21).

5. Air bearing device according to claim 3 or 4, **characterised in that** the gap-width monitoring device (26) has one or more monitoring sensors (27), by means of which the actual gap width is detectable and which gives a fault signal if there is a shortfall relative to a stored monitoring gap width.

6. Air bearing device according to claim 5, **characterised in that** the monitoring sensor is in the form of an air gap sensor.

7. Air bearing device according to claims 2, 3 and 6, **characterised in that** there is provided a control unit (28) which is connected on the one hand to the gap-width monitoring device (26) and on the other hand to the actuator (30) and/or the pressure regulator (24) and/or the volumetric flow regulator for controlled setting of the gap widths of the bearing gaps (22, 23).

## Revendications

1. Dispositif à palier à air, comprenant au moins un corps de palier (12, 13), qui présente une pluralité de canaux d'évacuation par écoulement (16) débouchant au niveau d'une face de palier (14, 15) du corps de palier (12, 13), à travers lesquels de l'air comprimé peut être acheminé, sachant que la face de palier (14, 15) coopère avec une face complémentaire (18, 19), tournée vers elle, d'un corps de substrat (25) de telle manière qu'un coussin d'air (20, 21) peut être produit par l'air comprimé évacué par écoulement entre la face de palier (14, 15) et la face complémentaire (18, 19), lequel coussin d'air crée un intervalle de palier (22, 23), les deux faces étant de ce fait disposées à distance l'une de l'autre conformément à une largeur d'intervalle de l'intervalle de palier (22, 23), sachant que le corps de palier (12, 13) fait partie intégrante en tant que premier corps de palier (12) d'un dispositif de serrage (40) pneumatique, qui présente, en complément, un deuxième corps de palier (13) pourvu d'une pluralité de canaux d'évacuation par écoulement (16) débouchant au niveau d'une deuxième face de palier (15) du deuxième corps de palier (13), sachant que les deux faces de palier (14, 15) se font face mutuellement et que le corps de substrat (25) peut être positionné entre les faces de palier (14, 15) de telle manière qu'il peut être immobilisé par serrage de manière pneumatique par les deux coussins d'air (20, 21) produits entre les faces de palier (14,15) et les faces complémentaires (18, 19) respectivement associées, de part et d'autre du corps de substrat (25), dans la position souhaitée, en direction perpendiculairement des faces de palier (14, 15), **caractérisé en ce qu'**un dispositif de réglage (29) servant à régler diverses distances entre les faces de palier (14, 15) des corps de palier (12, 13) est associé à au moins un des corps de palier (12, 13), sachant que le dispositif de réglage présente un entraînement de réglage, qui est couplé en déplacement au corps de palier (12, 13) associé par l'intermédiaire de moyens de transmission.

2. Dispositif à palier à air selon la revendication 1, **caractérisé en ce qu'**un régulateur de pression (24) et/ou un régulateur de flux volumique servant à régler différentes pressions et/ou flux volumiques de l'air comprimé circulant à travers les canaux d'évacuation par écoulement (16) et servant, ce faisant, à régler diverses largeurs d'intervalle est associé à au moins un des corps de palier (12, 13).

3. Dispositif à palier à air selon la revendication 1, **caractérisé par** un dispositif de surveillance des largeurs d'intervalle (26) servant à surveiller les largeurs d'intervalle des intervalles de palier (22, 23).

4. Dispositif à palier à air selon la revendication 3, **caractérisé en ce que** le dispositif de surveillance des largeurs d'intervalle (26) est réalisé de telle manière qu'une surveillance de la largeur d'intervalle est possible indépendamment de l'air comprimé produisant le coussin d'air (20, 21).

5. Dispositif à palier à air selon la revendication 3 ou 4, **caractérisé en ce que** le dispositif de surveillance des largeurs d'intervalle (26) présente au moins un capteur de surveillance (27), au moyen duquel des largeurs d'intervalle réelles peuvent être détectées et qui, en présence d'une valeur inférieure à une largeur d'intervalle minimale enregistrée, émet un signal d'erreur.

6. Dispositif à palier à air selon la revendication 5, **caractérisé en ce que** le capteur de surveillance est réalisé sous la forme d'un capteur d'entrefer.

7. Dispositif à palier à air selon la revendication 2, 3 et 6, **caractérisé en ce qu'**est prévu un dispositif de commande (28), qui est couplé d'une part au dispositif de surveillance des largeurs d'intervalle (26) et d'autre part à l'entraînement de réglage (30) et/ou au régulateur de pression (24) et/ou au régulateur de flux volumique servant à régler de manière commandée les largeurs d'intervalle des intervalles de palier (22, 23).
